# EUROPEAN PATENT APPLICATION

(11) **EP 0 591 887 A2**
(43) Date of publication of application: **13.04.1994**
(21) Application number: 93115970.1
(22) Date of filing: 04.10.1993
(51) Int. Cl.: H05K 1/05

(54) **Printed wiring board**

(30) Priority: 09.10.1992 JP 271303/92
(71) Applicant: International Business Machines Corporation, Armonk, N.Y. 10504 (US)
(72) Inventor: Endoh, Shuhichi, Fujisawa-shi, Kanagawa-ken (JP); Suga, Motoi, Tsukui-gunk, Kanagawa-ken (JP)
(74) Representative: Burt, Roger James, Dr.

(57) **Abstract**

To provide a metal cored printed wiring board and a manufacturing method therefore, in which an organic non-conductive layer (5) does not come off a metal core (1) even in an environment of high temperature and high humidity since both the metal core (1) and the organic non-conductive layer are firmly adhered, and copper plating (14) inside a through hole (2) can be easily performed.

An organic non-conductive layer (5) is formed over a metal core (1) made of aluminum etc. through such a metal plated layer for protection as a nickel layer (3) for protecting said metal core and a metal oxide layer for enforcing adhesive force. By utilizing said metal oxide layer (4) for enhancing adhesive force, it is possible to more effectively prevent the organic non-conductive layer (5) from coming off the metal core (1) in comparison with a case where adhesive of a series of organic resin materials is utilized. Further, said metal plated layer (3) for protection can protect the metal core (1) from erosion caused by contact with a strong alkali solution, etc. used in a process of forming said metal oxide layer (4) for enforcing adhesive force. Still further, since said metal plated layer (3) for protection protects the metal core (1) from erosion by a strong alkali solution used during the copper plating for a through hole (2), the copper plating (14) inside the through hole can be performed easily, that is, directly to the metal core (1).

## Description

### Field of the Invention

The present invention relates to a printed wiring board (PWB) whose core is made of metallic material such as aluminum.

### Background Art

Well-known as a printed wiring board are one whose core is made of organic insulating materials, one whose core is made of inorganic insulating materials such as ceramics, and a metal cored board whose core is made of metallic material. Of these boards, a board whose core is made of metal, especially aluminum, is excellent in heat radiation, mechanical strength, etc. and is suitable for a recent board for high density packaging. A conventional metal cored board whose core is made of aluminum, as disclosed in, for example, Japanese Published Unexamined Patent Applications (PUPAs) No. 61-131552, No. 62-132392, and No. 63-98179, generally has such construction that an organic non-conductive layer is formed over an Al core and a wiring layer is formed over the organic non-conductive layer. It is assumed that aluminum oxide is usually formed over the surface of the Al core.

However, in such conventional construction, since the adhesive force between the Al core and the organic non-conductive layer is insufficient, the organic non-conductive layer may come off the Al core in an environment of high temperature and high humidity. Further, in such conventional construction, when copper plating for a conductive path is performed on the inner surface of a pierced bore for a through hole formed in the Al core, the problem is caused that the Al core is eroded by a strong alkali solution used in the process of copper plating. Still further, the second figure in JA PUPA No.62-48089 shows a metal cored board in which a plated layer 2 made of easily solderable metal such as nickel is formed over a metal core 1 such as an Al core and an electrically insulating layer 3 is formed over the plated layer through an adhesive layer 5. However, since adhesive indicated as the adhesive layer 5 is limited to adhesive of an organic material family and the adhesive force between the plated layer 2 and the electrically insulating layer 3 is not necessarily sufficient, and an organic non-conductive layer may come off an Al core in an environment of high temperature and high humidity in the same manner as in the conventional construction described above.

Accordingly the invention provides a printed wiring board comprising a metal core, a metal plated layer for protecting the metal core, the metal plated layer being formed over the surface of the metal core, an adhesive force enhancing metal oxide layer for enhancing adhesive force onto the metal core, the metal oxide layer being formed over the metal plated layer, an organic non-conductive layer over the adhesive force enhancing metal oxide layer, and a wiring layer over the organic non-conductive layer.

Preferably the metal core is made of any of aluminum, aluminum alloy, magnesium, and magnesium alloy, the metal plated layer for protection is made of nickel, the adhesive force enhancing metal oxide layer is made of blackened copper, the organic non-conductive layer is an epoxy prepreg layer and the wiring layer is a copper wiring layer.

Also provided is a printed wiring board comprising an aluminum core in which a pierced bore for a through hole is formed, a nickel layer over the surface of the aluminum core including the inner surface of the through hole, a blackened copper layer over the nickel layer, a prepreg layer over the blackened copper layer and a copper wiring layer over the prepreg layer.

The invention also provides a method for manufacturing a printed wiring board, comprising the steps of forming a pierced bore for a through hole, as required, in an aluminum core, forming a nickel plated layer over the aluminum core after an oxide layer over the surface of the aluminum core is eliminated, forming a copper plated layer over the nickel layer, blackening the copper layer, forming an organic non-conductive layer over the blackened copper layer, and forming a wiring layer over the organic non-conductive layer.

### Brief Description of the Drawings

The invention will now be described, by way of example only, with reference to the accompanying drawings in which:
FIG.1 is a sectional view showing the structure of an embodiment of a printed wiring board according to the present invention;
FIG.2 is a sectional view showing the structure of an Al core used as a metal core in the embodiment of figure 1;
FIG.3 is a sectional view showing the structure in which a through hole is formed in the Al core of the embodiment of figure 1;
FIG.4 is a sectional view showing the structure in which a Ni layer as a metal plated layer for protection is formed over the Al core of the embodiment of figure 1;
FIG.5 is a sectional view showing the structure in which a copper layer is formed over said Ni layer of the embodiment of figure 1;
FIG.6 is a sectional view showing the structure in which said copper layer of the embodiment of figure 1 is blackened;
FIG.7 is a sectional view showing the structure in which an epoxy prepreg layer and a copper foil layer as organic material non-conductive layers are formed over said copper layer of the embodiment of figure 1;
FIG.8 is a sectional view showing the structure in which a through hole part of said epoxy prepreg layer and said copper foil layer of the embodiment of figure 1 is punched;
FIG.9 is a sectional view showing the structure in which a thin copper plated layer is formed over a laminated body of the embodiment of figure 1;
FIG.10 is a sectional view showing the structure in which a thick copper plated layer is formed over the thin copper plated layer of the embodiment of figure 1;
FIG.11 is a sectional view showing the structure in which a dry film masking layer is formed over the thick copper plated layer of the embodiment of figure 1;
FIG.12 is a sectional view showing the structure in which a solder pattern layer is formed over the thick copper plated layer of the embodiment of figure 1;
FIG.13 is a sectional view showing the structure in which the dry film masking layer is eliminated from over the thick copper plated layer of the embodiment of figure 1;
FIG.14 is a sectional view showing the structure in which a thick copper plated layer is eliminated from over the epoxy prepreg layer, except a thick copper plated layer under the solder pattern layer of the embodiment of figure 1;
FIG.15 is a sectional view showing the structure, in which the solder pattern layer is eliminated, of the embodiment of figure 1; and
FIG.16 is a sectional view showing the structure in which a solder resist layer of the embodiment of figure 1 is formed.

### Detailed Description of the Invention

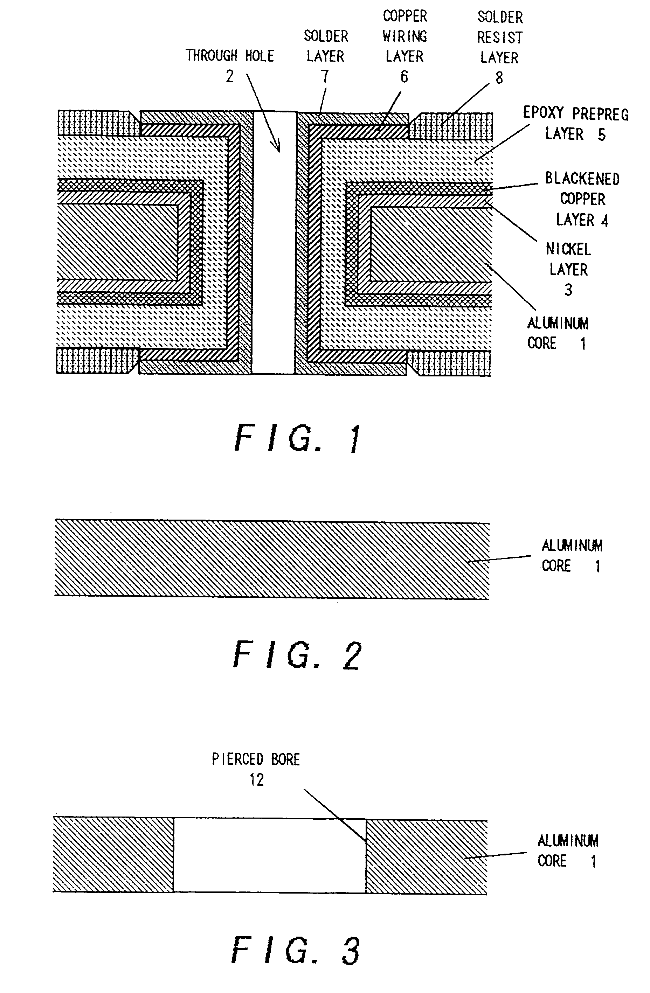

FIG.1 shows an embodiment of a printed wiring board according to the present invention. Formed in the printed wiring board whose core is an aluminum core 1 is a through hole 2. The surface of the Al core 1 is covered with a nickel layer 3 as a metal plated layer for protection. The surface of the Ni layer 3 is covered with a blackened copper layer 4 as a metal oxide layer for enhancing adhesive force. An epoxy prepreg layer 5 as an organic non-conductive layer is formed over the backened copper layer 4 and the nickel layer 3.

The copper layer 4, to which blackening treatment, a kind of oxidation treatment, was applied, enhances the adhesive force between the epoxy prepreg layer 5 and the Al core 1 since it has acicular structure and its surface area is increased. As described in detail later, to form the blackened copper layer 4, copper plating is first performed and then blackening treatment is applied to the copper plated layer. If the Al core 1 is soaked in a strong alkali solution during the copper plating, the Al core 1 will be eroded by the strong alkali solution. However, since the Al core 1 is protected by the Ni layer 3, the Al core 1 is not eroded even by the strong alkali solution. Such protective behavior by the Ni layer 3 cannot be obtained by an Al oxide layer.

The Ni layer 3 protects the Al core 1 not only from the strong alkali solution, but also from the process in which the copper plated layer is blackened. Further, the Ni layer 3 is firmly linked to the Al core 1 by metallic bonding and is firmly linked also to the copper plated layer. Accordingly, the epoxy prepreg layer 5 can be firmly linked to the Al core 1.

Formed over the epoxy prepreg layer 5 is a copper wiring layer 6 as a wiring layer, and formed over the copper wiring layer 6 is a solder layer 7. The copper wiring layer 6 and the solder layer 7 are also formed inside the through hole 2. A solder resist layer 8 is formed over an area of the surface of the epoxy prepreg layer 5 where the copper wiring layer 6 is not formed.

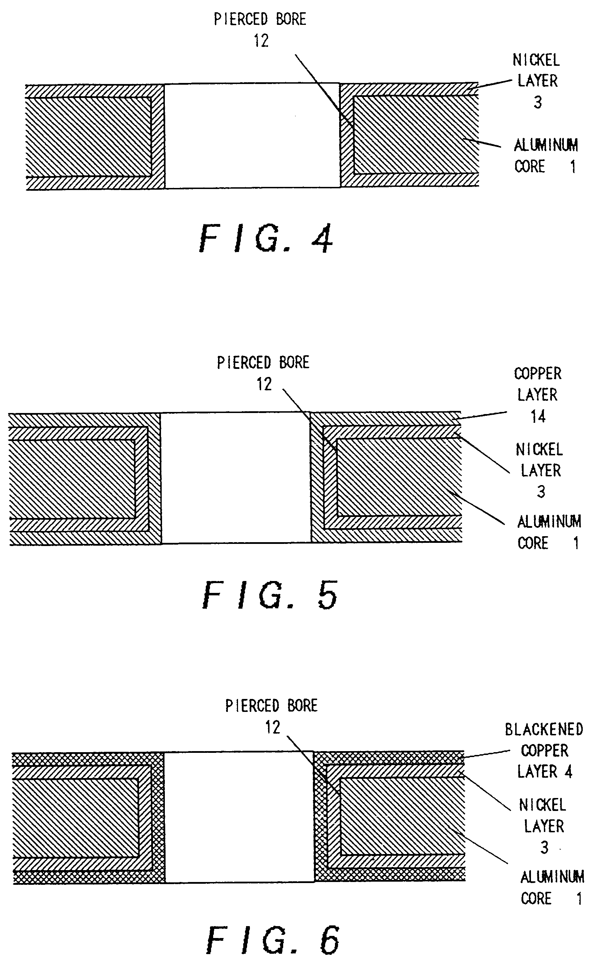

In the following, an embodiment of a manufacturing method according to the present invention is described by reference to FIG.2 to FIG.16 as well. By drilling such an Al core 1 as shown in FIG.2 a pierced bore 12 for a through hole is formed as shown in FIG.3. Then, as shown in FIG.4, the Ni layer 3 is formed over the surface of the Al core 1 including the pierced bore 12 for a through hole.

In the following, an example of a method for forming the Ni layer 3 is described in detail. First, the Al core 1 is soaked in a degreasing solution to remove grease. For example, the Al core 1 is soaked, for six minutes, in the solution of "Top Alclean 160" by OKUNO Chemical Industries Co., Ltd. whose concentration is 40 to 60 g/l and temperature is 55 to 60 C. The degreased Al core 1 is washed in water, neutralized, and washed in water again. The neutralisation process is performed, for example, by soaking the Al core 1, at the ordinary temperature for one minute, in a 67% nitric acid solution whose concentration is 350 to 450 g/l. Then, an Al oxide layer over the surface of the Al core 1 is eliminated by etching the Al core 1. The etching is performed, for example, by soaking the Al core 1, for 30 to 90 seconds, in sodium hydroxide whose concentration is 75 to 100 g/l and temperature is 55 to 60 C.

After the Al oxide layer is eliminated, the Al core 1 is washed in water, neutralised on nearly the same condition as the above case, and washed in water again. Then, by soaking the Al core 1, for 20 to 30 seconds, in a desmat solution whose temperature is 20 to 30 C, for example, "ADD320" by OKUNO Chemical Industries, active desmat process is performed to the surface of the Al core 1, and the Al core 1 is washed in water and then washed by a water shower.

Then, the Ni layer 3 is formed over the surface of the Al core 1 by electroless plating. Used as a plating solution is, for example, one whose Ni concentration is 5.0 to 5.7 g/l, pH is 4.3 to 4.7, processing time is 8 to 40 minutes, and processing temperature is 85 to 92 C. For example, "Top Nicoron BL" by OKUNO Chemical Industries can be used as a plating solution. After the Ni layer 3 is formed over the Al core 1, the Al core 1 is washed in water, washed in hot water, washed in pure water, and dried in 80 C or so.

Then, as shown in FIG.5, a copper layer 14 is formed over the Ni layer 3 by means of electroless plating. First, the Al core 1 is degreased. After the Al core 1 is soaked in a solvent whose processing temperature is 50 to 60 C to remove grease preparatively, vapor degreasing is performed by soaking the Al core 1 in a degreasing solution for four minutes at the processing temperature of 45 to 55 C. "Trisen" by KANTO DENKA KOGYO Co., Ltd. can be used as a solvent for preparative degreasing process. "Ace Clean 5300" by OKUNO Chemical Industries can be used as a degreasing solution for boiling degreasing. After being washed in water, the Al core 1 is electrolytically degreased and then washed in water. The electrolytic degreasing is performed by soaking the Al core 1 in sodium hydroxide whose concentration is 45 to 55 g/l for two minutes and thirty seconds at the processing temperature of 30 to 45 C. "Top Cleaner E" by KANTO DENKA KOGYO can be used as sodium hydroxide.

After the electrolytic degreasing process, the Al core 1 is washed in water, soaked in hydrochloric acid, and washed in water again. A 35% hydrochloric acid solution is used for the hydrochloric acid soaking. Then, cyanogen neutralisation process is performed. For the cyanogen neutralisation process, free soda cyanide whose concentration is 40 to 50 g/l is used as a cyanogen neutralising solution. Then, strike copper plating process is performed to the Al core 1. A plating solution used for the strike copper plating comprises sodium carbonate whose concentration is 100 g/l and less, first copper cyanide whose concentration is 35 to 45 g/l, and free soda cyanide whose concentration is 8 to 12 g/l. Its processing temperature is 45 to 55 C and its processing time is 45 seconds.

After the strike copper plating process, copper plating process is performed to the Al core 1. A plating solution used for the copper plating comprises sodium carbonate whose concentration is 100 g/l and less, first copper cyanide whose concentration is 60 to 100 g/l, and free soda cyanide whose concentration is 8 to 10 g/l. Its processing temperature is 50 to 60 C and its processing time is 8 minutes. After the copper plating process, the Al core 1 is washed in water.

Then, the copper layer 14 is blackened to form the blackened copper layer 4 as shown in FIG.6. The blackening treatment of the copper layer 14 can be performed in the following way. First, soft etching process is performed to the copper layer 14. An etching solution used for the soft etching comprises hydrochloric acid and cupric chloride, and its processing temperature is 30 C and its processing time is one minute and a half. After the soft etching process, the surface of the copper layer 14 is activated by soaking it, for two minutes and a half, in hydrochloric acid whose temperature is 30 C and is washed in pure water. Secondly, the copper layer 14 is blackened by processing the Al core 1, for three minutes and a half at the temperature of 60 C, by a processing solution which comprises sodium hydroxide and potassium persulfate, and then the Al core 1 is dried.

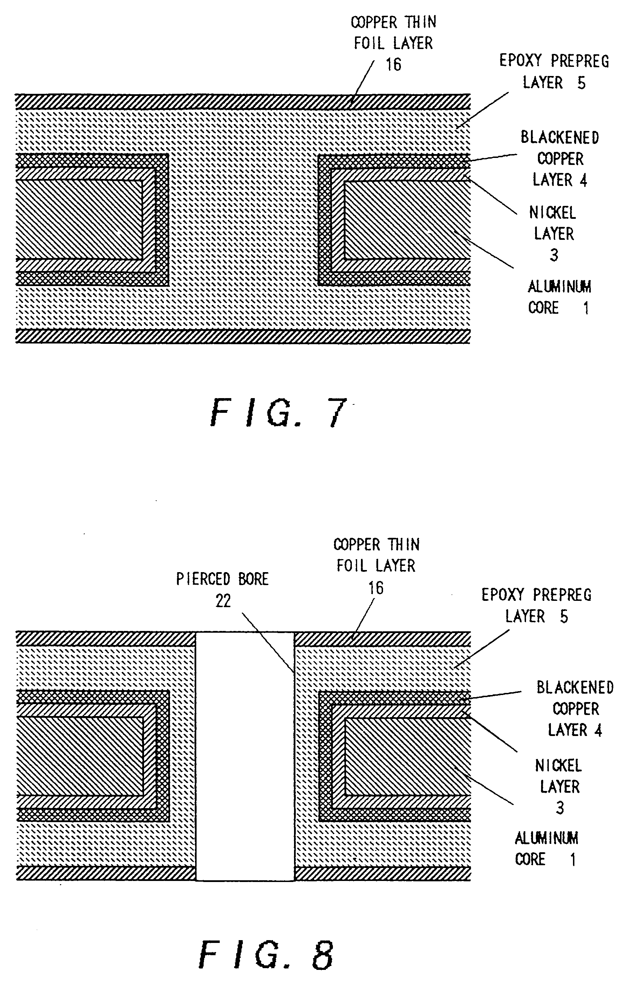

Then, after epoxy prepreg is piled on the upper and lower sides of the Al core 1 and then copper foil is piled on it, they are laminated by thermal pressurization, and therefore the epoxy prepreg layer 5 and copper thin foil layer 16 are formed as shown in FIG.7. The pierced bore 12 for a through hole is blocked by epoxy resin oozed from the epoxy prepreg during the thermal pressurization of the epoxy prepreg. If an amount of epoxy resins oozed from the epoxy prepreg is not enough to block the pierced bore 12 for a through hole, a proper amount of epoxy resin may be previously stuffed into the pierced bore 12 for a through hole.

Then, as shown in FIG. 8, a pierced bore 22 for a through hole is punched in the epoxy prepreg layer 5 by drilling processing. As the aftertreatment of drilling (deburring treatment), the laminated body may be processed, at the temperature of 38 C and less and for five minutes, by "Mercutizer 9204" provided by Nihon Mukdermit, and then it may be processed, at the temperature of 75 C or less and for six minutes, by "Mercutizers 9275 and 9276" by the said firm, and then it may be processed, at the temperature of 43 C or less and for one minute, by Mercutizer 9279 by the said firm.

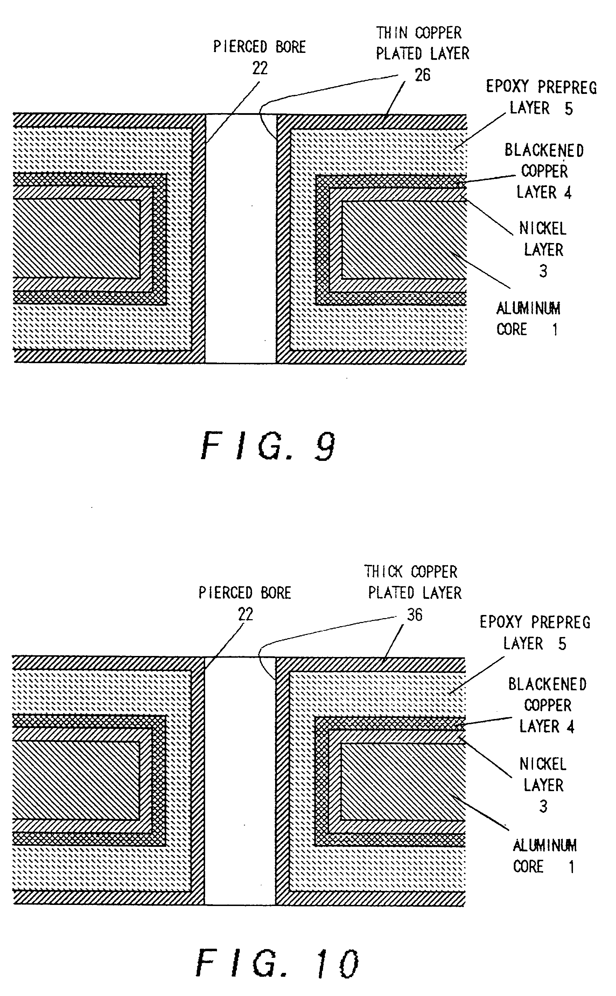

Then, as shown in FIG.9, a thin copper plated layer 26 is formed by performing electroless plating to the surface of the laminated body including the pierced bore 22 for a through hole. The electroless plating can be performed in the following way. For example, after the laminated body is degreased by means of such a degreasing solvent as "CLC 201" by Hitachi Chemical Co., Ltd., soft etching is performed, for two minutes, to the laminated body by ammonium persulfide whose temperature is 25 C. After that, the surface is activated by salt solution whose temperature is 20 C, processed to improve sensitivity by "HS-201" by Hitachi Chemical (at 25 C and for six minutes), and processed to improve adhesion by "ADP 301" by Hitachi Chemical (at 25 C and for six minutes). Then, electroless plating (at 22 C and for 15 minutes) is performed to the surface using "CUST 201" by Hitachi Chemical as an electroless plating solution for copper, and thus the thin copper plated layer 26 is formed over the epoxy prepreg layer 5.

Then, as shown in FIG.10, a thick copper plated layer 36 is formed by performing electrolytic plating of copper. The electrolytic plating can be performed in the following way. First, after the laminated body is washed (at 25 C and for one minute) by dilute sulfuric acid (concentration of 10%), primary electrolytic plating is performed. For the primary electrolytic plating, for example, "PYROBRITEOPY-66 or -67" by C. Uyemura & Co., Ltd. can be used as a plating solution. Its processing temperature is 55 C and its processing time is four minutes.

Secondly, secondary electrolytic plating is performed. For the secondary electrolytic plating, for example, "Copperglim PCM" by Meltex can be used as a plating solution. Its processing temperature is 25 C and its processing time is 30 to 50 minutes. Before the secondary electrolytic plating, degreasing process, soft etching, and acid washing are performed. "PC 455" by Meltex can be used for the degreasing process (at 30 C and for 4 minutes), "CPE-500" by MITSUBISHI GAS CHEMICAL Co., Ltd. can be used for the soft etching (at 25 C and for 2 minutes), and dilute sulfuric acid can be used for the acid washing (at 25 C and for 3 minutes).

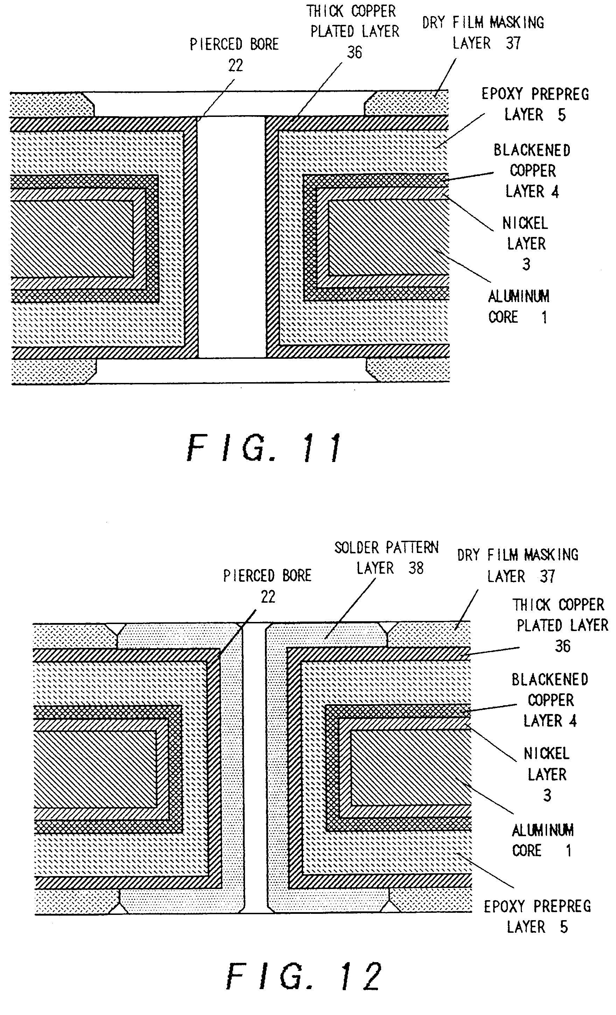

Then, a photosensitive dry film (photo resist) is piled over the copper plated layer 36, the dry film is exposed through a wiring pattern and developed, and thus a dry film masking layer 37 is formed as shown in FIG.11. "Lyston Type 1020" by Du Pont de Nemours & Co. can be used as a dry film. Then, as shown in FIG.12, a solder pattern layer 38 is formed, by electrolytic plating, over a part which is not masked by the dry film masking layer 37. The solder pattern layer 38 is used as a resist when a wiring pattern of copper is formed by etching the thick copper plated layer 36 later. For the solder plating process, "Plutin LA" by Meltex can be used as a plating solution (at 25 C and for 9 to 12 minutes).

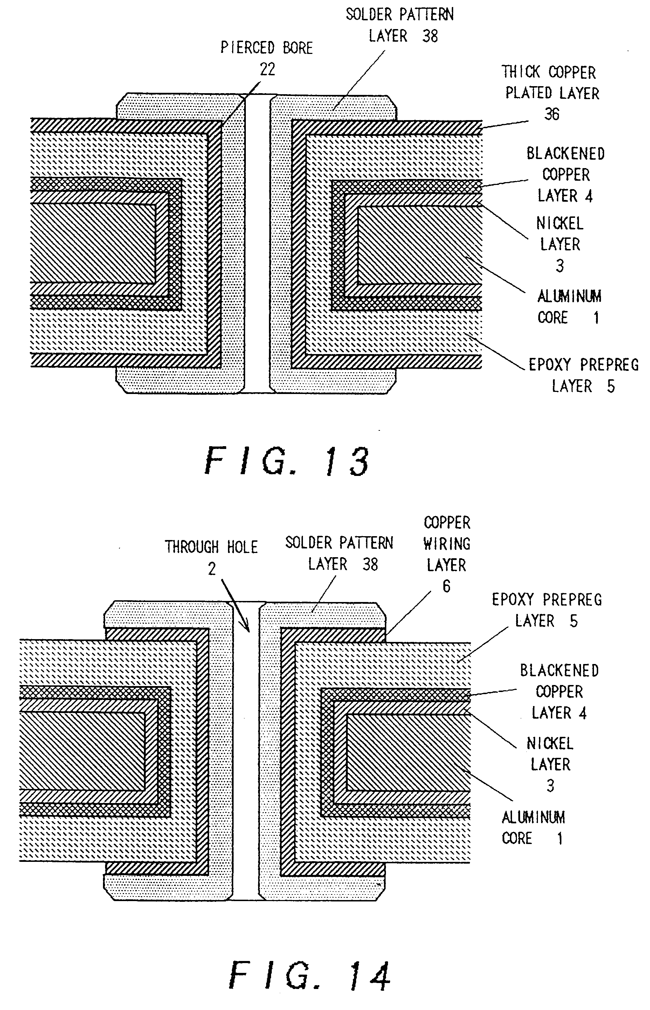

Then, as shown in FIG. 13, the dry film masking layer 37 is eliminated by such a solvent for a resist as methylene chloride and only the solder pattern layer 38 is left over the copper plated layer 36. "AP-205A" by Tokuyama Soda Co., Ltd. can be used as a solvent for a resist. After that, as shown in FIG.14, the copper plated layer 36, except the part which is covered with the solder pattern layer 38, is eliminated by etching. "A-Process" by Meltex can be used as an etching solvent. For example, its processing temperature is 30 C and its processing time is 50 to 60 seconds. The copper wiring layer 6 is left under the solder pattern layer 38 by etching the copper plated layer 36 in consideration of the solder pattern layer 38 as a resist for etching as described above.

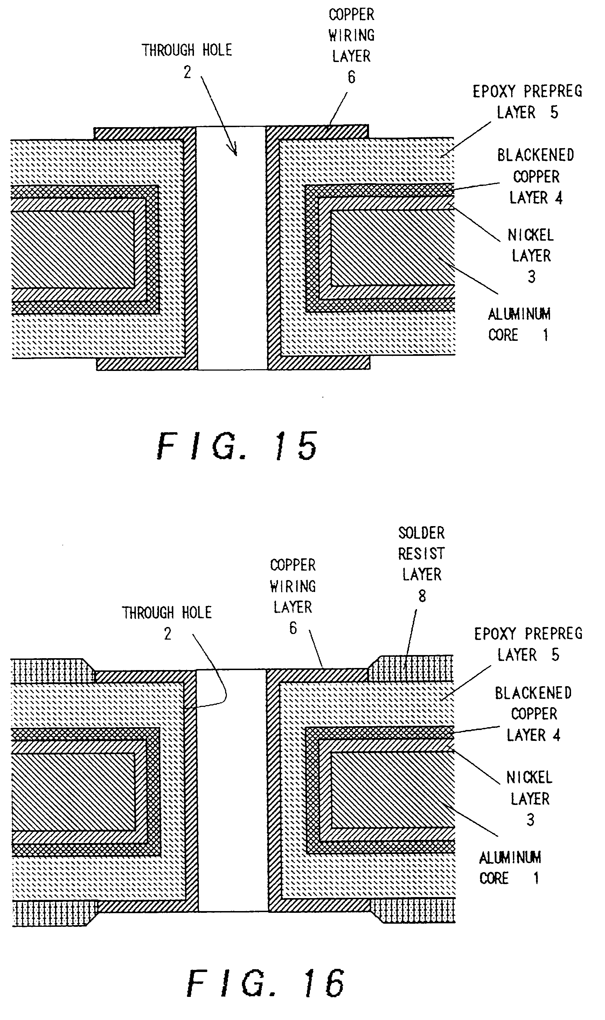

Then, as shown in FIG.15, the solder pattern layer 38 is peeled from the copper wiring layer 36. The peeling of the solder pattern layer 38 is performed by liquefying solder using an etching solution of a nitric acid series. "S-81" by MEC Co., Ltd. can be used as such an etching solution. For example, its processing temperature is 40 to 45 C and its processing time is 80 to 90 seconds. Then, as shown in FIG.16, the solder resist layer 8 is formed over the surface of the epoxy prepreg layer 5, except the part on which the copper wiring layer 36 is formed. The formation of the solder resist layer 8 can be performed by applying a photosensitive solder resist solution to the laminated body by printing, exposing it through a wiring pattern, and developing it after the rust of the laminated body is removed.

"CB-530" by Nihon Hyomen Kagaku Co., Ltd. can be used as a solvent for derusting and adherence process. Then, for example, its processing temperature is 27 to 30 C and its processing time is 10 seconds or so. The solder resist layer 8 can be formed by applying a photosensitive solder resist solution to the laminated body by printing, exposing it through a wiring pattern, developing it, and performing hot setting process (for example, at the temperature of 140 C) to it. "CB-530" by Nihon Hyomen Kagaku can be used as a solvent for derusting and adherence process. Then, for example, its processing temperature is 27 to 30 C and its processing time is 10 seconds or so. "PSR-4000" by TAIYO INK MANUFACTURING Co., Ltd. whose main component is epoxy resin, can be used as a photosensitive solder resist solution. Various marks may be attached on the solder resist layer 8 by silk printing.

Then, as shown in FIG.1, the solder layer 7 is formed only over the copper wiring layer 6. The solder layer 7 is intended not only to prevent the copper wiring layer 6 from being oxidized, but also to make the soldering to the copper wiring layer 6 easy. When the laminated body is soaked in a soldering solution after the surface of the laminated body is processed by a surface treatment solvent, the solder layer 7 is adherently formed only over the copper wiring layer 6. "CA-91" by MEC can be used as a surface treatment solvent. For example, its processing temperature is 30 C and its processing time is 10 to 20 seconds. "Solcoat H63A (solder)" by Solcoat Inc. can be used as a soldering solution. A flux layer may be formed over the solder layer 7. The flux layer may be formed using, for example, "W-139 (flux)" by MEC.

According to such an embodiment as described above, it is possible to use the blackened copper layer 4 whose adhesive behavior is extremely strong, so as to make the epoxy prepreg layer 5 adhere over the Al core 1 since the Ni layer 3 can protect the Al core 1 from the attack by the strong alkali solution used during the formation of the copper plated layer 14. Moreover, there is an effect that an Al core is not eroded even in the formation of a printed wiring board having such a multilayer structure as needs a plurality of copper plating processes since the Ni layer 3 protects the Al core 1 also from the attack by the strong alkali solution used when the copper wiring layer 6 is formed by plating. Further, there is an effect that copper plating can be performed directly to a through hole.

Besides, though a core is made of aluminum in said embodiment, it will be appreciated that the present invention may be applied to a case where a core is made of metal other than aluminum, for example, aluminum alloy, magnesium, magnesium alloy, etc. Further, it will be appreciated also that a metal plated layer for protection, though it is a Ni layer in said embodiment, may be other metal layers, for example, a chrome layer, an iron layer, etc. Still further, it will be appreciated also that a non-conductive layer made of organic material, though it is an epoxy prepreg layer in said embodiment, may be a non-conductive layer made of organic material other than an epoxy prepreg layer.

## Claims

1. A printed wiring board comprising;
a metal core (1);
a metal plated layer (14) for protecting said metal core (1), said metal plated layer (14) being formed over the surface of said metal core (1);
an adhesive force enhancing metal oxide layer (4) for enhancing adhesive force onto said metal core (1), said metal oxide layer (4) being formed over said metal plated layer (14);
an organic non-conductive layer (5) over said adhesive force enhancing metal oxide layer (4); and
a wiring layer (6) over said organic non-conductive layer (5).

2. A printed wiring board as claimed in claim 1, wherein said metal core (1) is made of any of aluminum, aluminum alloy, magnesium, and magnesium alloy.

3. A printed wiring board as claimed in any preceding claim, wherein said metal plated layer (3) for protection is made of nickel.

4. A printed wiring board as claimed in any preceding claim, wherein said adhesive force enhancing metal oxide layer (4) is made of blackened copper.

5. A printed wiring board as claimed in any preceding claim, wherein said organic non-conductive layer (5) is an epoxy prepreg layer.

6. A printed wiring board as claimed in any preceding claim, wherein said wiring layer (6) is a copper wiring layer.

7. A printed wiring board comprising;
an aluminum core (1) in which a pierced bore (12,22) for a through hole (2) is formed;
a nickel layer (3) over the surface of said aluminum core including the inner surface of said through hole (2);
a blackened copper layer (4) over said nickel layer (3);
a prepreg layer (5) over said blackened copper layer (4); and
a copper wiring layer (6) over said prepreg layer (5).

8. A method for manufacturing a printed wiring board, comprising the steps of:
forming a pierced bore (12,22) for a through hole (2), as required, in an aluminum core (1);
forming a nickel plated layer (3) over said aluminum core (1) after an oxide layer over the surface of said aluminum core (1) is eliminated;
forming a copper plated layer (14) over said nickel layer (3);
blackening said copper layer (14);
forming an organic non-conductive layer (5) over said blackened copper layer (14); and
forming a wiring layer (6) over said organic non-conductive layer (5).
